Europäisches Patentamt

European Patent Office

Office européen des brevets

(11) Veröffentlichungsnummer: **0 520 308 A2**

## (12) EUROPÄISCHE PATENTANMELDUNG

(21) Anmeldenummer: **92110193.7**

(22) Anmeldetag: **17.06.92**

(51) Int. Cl.5: **H01P 5/02**

(30) Priorität: **27.06.91 DE 4121273**
**12.12.91 DE 4140975**

(43) Veröffentlichungstag der Anmeldung:
**30.12.92 Patentblatt 92/53**

(84) Benannte Vertragsstaaten:
**AT BE CH DE DK ES FR GB IT LI NL SE**

(71) Anmelder: **Alcatel SEL Aktiengesellschaft**
**Lorenzstrasse 10**
**W-7000 Stuttgart 40(DE)**
㊸ **DE**

(71) Anmelder: **ALCATEL N.V.**
**Strawinskylaan 341 (World Trade Center)**

**NL-1077 XX Amsterdam(NL)**

㊸ **BE CH DK ES FR GB IT LI NL SE AT**

(72) Erfinder: **Heidemann, Rolf, Dr.**
**Weinsberger Weg 14**
**W-7146 Tamm(DE)**
Erfinder: **Braun, Klaus**
**Tübinger Strasse 11**
**W-7408 Kusterdingen(DE)**

(74) Vertreter: **Kugler, Hermann, Dipl.-Phys. et al**
**Alcatel SEL AG Patent- und Lizenzwesen**
**Postfach 30 09 29**
**W-7000 Stuttgart 30(DE)**

(54) **Verstärkende Schaltungsanordnung.**

㉕ Bei einer verstärkenden Schaltungsanordnung, z.B. für einen optischen Empfänger mit einem hochohmigen Ausgang des lichtempfindlichen Bauelements, wird dieser über einen abgestimmten $\frac{\lambda}{4}$-Kreis mit entsprechend gewählten Anzapfungen an einem rauscharmen, niederohmigen Verstärker angepaßt.

In einem relativ schmalen Frequenzbereich bietet der optische Empfänger eine größere Empfindlichkeit. Er ist außerdem frequenzselektiv und vermeidet den großen Schaltungsaufwand herkömmlicher optischer Empfänger.

Breitbandig verstärkende Schaltungsanordnungen, insbesondere optische Empfänger (E) für z.B. Kabelfernsehanlagen, enthalten ein passives Empfangsmodul (PM) zur verzerrungsarmen Wandlung breitbandiger optischer Analogsignale in elektrische Signale. Zur Impedanzanpassung eines lichtempfindlichen Elements (PD) an die Eingangsimpedanz eines nachgeschalteten Breitbandverstärkers (BK) enthält das passive Empfangsmodul (PM) einen Übertrager (UE).

FIG.3

Fig.4

Die Erfindung betrifft eine verstärkende Schaltungsanordnung gemäß dem Oberbegriff des Anspruchs 1.

Solche Schaltungsanordnungen dienen z.B. in optischen Empfängern zur Umwandlung von optischen Signalen in elektrische Signale und zur Vorverstärkung dieser elektrischen Signale.

Bei optischen Übertragungssystemen mit einem optischen Empfänger hoher Empfindlichkeit in einem relativ schmalen Frequenzbereich mit einem lichtempfindlichen Bauelement (Photodiode) und einem nachgeschalteten Verstärker können die Leistungspegel des von einem optischen Empfänger zu verarbeitenden optischen Empfangssignals sehr unterschiedlich sein. Der Empfänger muß deshalb in der Lage sein, sowohl sehr kleine, als auch sehr große Lichtpegel fehlerfrei zu detektieren. Die untere Grenze bezeichnet man als Empfängerempfindlichkeit. Sie ist im wesentlichen abhängig von den Rauscheigenschaften des Detektorelements, das als lichtempfindliches Bauelement ausgebildet ist. Ferner hängt die Empfängerempfindlichkeit von der Schaltung eines im optischen Empfänger verwendeten Verstärkers ab.

In "Geisler, J.A.; Optical fibres; (EPO applied technology series; V. 5); 1986", Part III, Chapter III, Seiten 437 - 526 wird eine Vielfalt von optischen Empfängern beschrieben. Die dort beschriebenen optischen Empfänger weisen einen großen Schaltungsaufwand für den, dem lichtempfindlichen Bauelement nachgeschalteten, Verstärker auf, wobei der Verstärker als "High-impedance"-Verstärker oder als Transimpedanzverstärker realisiert wird. Strebt man einen großen Dynamikbereich an, dann werden bevorzugt optische Empfänger mit einem Transimpedanzverstärker eingesetzt. Ein solcher optischer Empfänger mit einem Transimpedanzverstärker ist z.B. aus der DE-A1 39 38 097 bekannt. Transimpedanzverstärker sind möglichst hochohmig am Eingang und über einen breiten Frequenzbereich einsetzbar. Sie übernehmen die Funktion eines Strom-Spannungs-Wandlers, der den elektrischen Strom aus dem lichtempfindlichen Bauelement in eine Spannung umwandelt. Der Nachteil eines solchen Verstärkertyps liegt in dem verschlechterten Signal-Rausch-Verhältnis, was eine Beschränkung der Empfängerempfindlichkeit mit sich bringt.

Bekannte breitbandig verstärkende Schaltungsanordnungen werden z.B. für optische Breitbandempfänger in optischen CATV- und Digitalen-Kommunikationssystemen verwendet. Ein kostengünstiger optischer Breitbandempfänger für analoge amplitudenmodulierte Signale mit dem Bandbereich von 50 Mhz bis 550 Mhz ist aus der Schrift EP 0 372 742 A2 bekannt. Der bekannte Empfänger besteht aus einem lichtempfindlichen Bauelement, das, zur Impedanzanpassung über einen Übertrager, mit einem breitbandigen, niederohmigen Verstärker verbunden ist.

Der Nachteil des bekannten Empfängers liegt nun darin, daß das lichtempfindliche Bauelement trotz Impedanzanpassung einen schlechten Ausgangsreflexionsfaktor zeigt, der im Verstärker starkes Klirren höherer Ordnung bewirkt.

Der Erfindung liegt nun die Aufgabe zugrunde, eine verstärkende Schaltungsanordnung mit vergrößerter Empfindlichkeit zu schaffen, bei der beim Verstärken breitbandiger Signale nichtlineare Verzerrungen, wie Klirren zweiter Ordnung, weitgehend verhindert werden.

Diese Aufgabe wird durch die Merkmale des Anspruchs 1 gelöst.

Vorteilhafte Ausgestaltungen sind den abhängigen Ansprüchen zu entnehmen.

Ausführungsbeispiele der Erfindung werden im folgenden anhand der Figuren 1 bis 5 beschrieben. Die Figuren zeigen:

Fig. 1     Prinzip eines $\frac{\lambda}{4}$-Kreis und Variation des Wellenwiderstandes in Abhängigkeit von der Länge,

Fig. 2     $\frac{\lambda}{4}$-Kreis mit Ersatzschaltbild der Photodiode,

Fig. 3     Prinzipschaltbild eines ersten Ausführungsbeispiels,

Fig. 4     ein zweites Ausführungsbeispiel der Erfindung, und

Fig. 5     die Reduzierung des Klirrens unter dem Einfluß des $\lambda/4$-Kreises über der Frequenz aufgetragen.

Im ersten Ausführungsbeispiel wird die Schaltungsanordnung in einem schmalbandigen optischen Empfänger eingesetzt. Als lichtempfindliches Bauelement dient im optischen Empfänger eine Photodiode. Die Photodiode besitzt eine Kapazität von z.B. $C \approx 1pF$ und eine Ausgangssimpedanz im $k\Omega$-Bereich. Durch die abgestimmten $\frac{\lambda}{4}$-Kreise wird das Signal aus der Photodiode an einen Verstärker mit einer Eingangsimpedanz von z.B. $Z_e = 50\Omega$ angepaßt.

Der erfindungsgemäße optische Empfänger des ersten Ausführungsbeispiels ist besonders für den Einsatz in einem relativ schmalen Frequenzbereich, z.B. beim Mobilfunksystem DECT: 1880 - 1900 MHz, geeignet. Außerdem ist der optische Empfänger selektiv. Dadurch werden Störsignale, die außerhalb des Empfindlichkeitsfrequenzbereiches auftreten, unterdrückt.

Eine vorteilhafte Weiterbildung des Empfängers besteht darin, daß der Frequenzbereich über einen optionalen Abstimmkondensator variiert werden kann.

Benutzt man zur Anpassung einen $n \cdot \frac{\lambda}{4}$-Kreis ($n = 1, 3, 5, \ldots$ d.h. ungerade), so ist der optische Empfänger auf mehrere, harmonisch liegende Frequenzen abgestimmt.

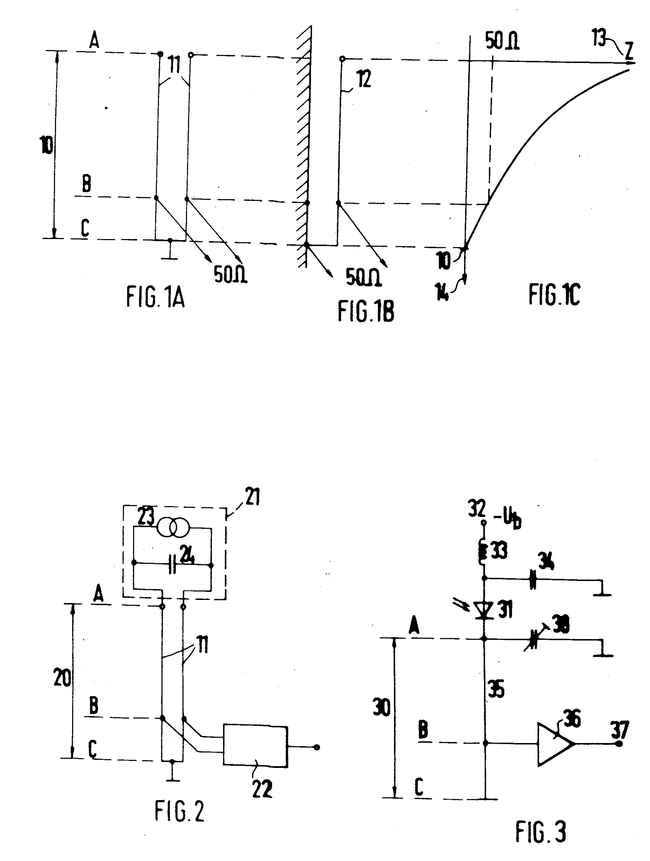

In Teil 1A von Fig. 1 wird die Ausführung des $\frac{\lambda}{4}$ -Kreises als Paralleldrahtleitung 11 der Länge 10 gezeigt. Eine weitere Ausführungsform des $\frac{\lambda}{4}$ -Kreises stellt Teil 1B von Fig. 1 dar, der eine "Stripline"-Ausführung des $\frac{\lambda}{4}$ -Kreises darstellt. Der $\frac{\lambda}{4}$ -Kreis besteht dabei aus einer einzigen Leitung 12.

Teil 1C der Fig. 1 beschreibt den Verlauf der Impedanz 13 über der Länge 14 der Leitung(en) des $\frac{\lambda}{4}$ -Kreises. Allen drei Teilen (1A, 1B, 1C) der Fig. 1 sind die Bezugslinien A, B und C gemeinsam.:

Die Bezugslinie A stellt den Anfangspunkt des $\frac{\lambda}{4}$ -Kreises dar. An dieser Stelle ist die Impedanz des $\frac{\lambda}{4}$ -Kreises hoch. Bezugslinie B beschreibt die Stelle des $\frac{\lambda}{4}$ -Kreises, an dem der $\frac{\lambda}{4}$ -Kreis einen Wellenwiderstand von 50Ω aufweist. An dieser Stelle wird ein Verstärker mit einer Eingangsimpedanz von 50Ω angeschlossen. Die Bezugslinie C stellt die Stelle des $\frac{\lambda}{4}$ -Kreises dar, an dem die der $\frac{\lambda}{4}$ -Kreis kurzgeschlossen wird. Den Abstand zwischen den Stellen mit den Bezugslinien A und C bezeichnet man als Länge des $\frac{\lambda}{4}$ -Kreises.

Die Bezugslinien A, B und C, sowie einige andere Bezugszeichen, erscheinen in mehreren Figuren. Gleiche Bezugszeichen oder Bezugslinien bezeichnen nachfolgend die gleichen Elemente oder Stellen des erfindungsgemäßen optischen Empfängers.

In Fig. 2 hat die Photodiode, deren Ersatzschaltbild durch eine Schaltung 21 gezeigt ist, eine hohe Ausgangsimpedanz (bei Bezugslinie A) und im Ersatzschaltbild kann sie als eine Stromquelle 23 mit einem parallel geschalteten Kondensator 24 betrachtet werden. Der $\frac{\lambda}{4}$ -Kreis wird der Photodiode 21 nachgeschaltet.

Für die Bestimmung der Länge 20 des $\frac{\lambda}{4}$ -Kreises muß die Tatsasche berücksichtigt werden, daß der Kondensator 24 eine kapazitive Verkürzung des $\frac{\lambda}{4}$ -Kreises verursacht. Die Länge 20 ist dadurch kleiner als die Länge 10 eines theoretisch bestimmten, unbelasteten $\frac{\lambda}{4}$ -Kreises.

Die Anzapfung der Leitung mit der Länge 20 erfolgt an der Stelle bei der Bezugslinie B, d.h. an der Stelle, wo der $\frac{\lambda}{4}$ -Kreis eineImpedanaz gleich der Eingangsimpedanz des Verstärkers, z.b. 50Ω hat. An dieser Stelle wird der Verstärker 22 verlustlos angepaßt.

Fig. 3 zeigt ein Prinzipschaltbild des erfindungsgemäßen optischen Empfängers. Der Photodiode 31 werden Lichtsignale über eine nicht dargestellte Lichtwellenleiter eines optischen Übertragungssystems zugeleitet.

Die Anode der Photodiode 31 ist mit dem negativen Pol einer Versorgungsspannungsquelle 32 über eine Drosselspule 33 verbunden. Die Drosselspule 33 dient zur Entkopplung hochfrequenter Signalanteile, indem sie eine Sperre für Wechselströme höherer Frequenzen darstellt, während niedrigere Frequenzen oder Gleichstrom einen guten Durchgang vorfinden.

Die Anode der Photodiode ist ebenfalls mit einem Kondensator 34 verbunden, der seinerseits mit dem Massepotential verbunden ist. Dadurch wird die Anode für hohe Frequenzen auf Masse gelegt, während sie für Gleichstrom auf dem negativen Potential der Versorgungsspannugnsquelle 32 liegt. Aufgrund seiner Funktion wird der Kondensator 34 als "Block-Kondensator" definiert.

Die Kathode der Photodiode 31 ist direkt mit dem $\frac{\lambda}{4}$ -Kreis 35 der Länge 30 verbunden. Die Anzapfung des $\frac{\lambda}{4}$ -Kreises erfolgt bei der Stelle, an der der Wellenwiderstand des $\frac{\lambda}{4}$ -Kreises 50Ω beträgt. Diese Stelle entspricht der Bezugslinie B in Fig. 3. An dieser Stelle wird ein rauscharmer Verstärker 36 mit einer Eingangsimpedanz von 50Ω angeschlossen. Am Ausgang 37 des Verstärkers 36 liegt eine Spannung vor, die proportional zu dem, von der Photodiode 31 erzeugten, Photostrom ist.

Mit einer weiteren Schaltungsvariante läßt sich der Frequenzbereich des optischen Empfängers variieren. Diese Variante liegt vor, wenn an der Kathode der Photodiode 31 ein Abstimmkondensator 38 angeschlossen wird, der seinerseits mit dem Massepotential verbunden ist. Durch diesen (verlustlosen, nicht rauschenden) Abstimmkondensator 38 ist die elektrisch wirksame Länge und damit die Resonanzfrequenz des $\frac{\lambda}{4}$ -Kreises einstellbar. Die Kapazität liegt parallel zu der der Photodiode. Wenn der $\frac{\lambda}{4}$ -Kreis ein $n \cdot \frac{\lambda}{4}$ -Kreis (n = 1, 3, 5 ...) ist, ist der Empfänger auf mehrere, harmonisch liegende Frequenzen abgestimmt. Durch Anschaltung von Abstimmkondensatoren 38 (zusätzlich zur Photodiode 31) können nahezu beliebige Empfangsfrequenzen eingestellt werden (z.B. 900 MHz für CT1 und 1900 MHz für DECT).

Das zweite Ausführungsbeispiel betrifft nun eine vorteilhafte Ausgestaltung, zur Impedanzanpassung einer Signalquelle mit hochohmiger komplexer Ausgangsimpedanz an einen niederohmigen Verstärker einer breitbandigen, verstärkenden Schaltungsanordnung.

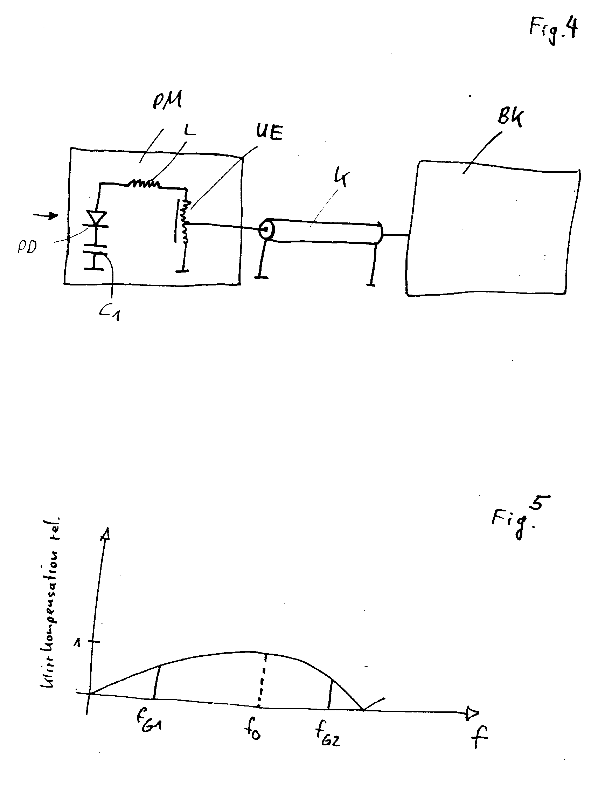

Im zweiten Ausführungsbeispiel ist als breitbandig verstärkende Schaltungsanordnung ein optischer Breitbandempfänger in Figur 4 abgebildet. Der gezeigte Breitbandempfänger E besteht aus einem PIN-Modul PM, einem λ/4-Kreis K und einem niederohmigen Breitbandverstärker BK. Im PIN-Modul ist eine PIN-Photodiode als lichtempfindliches Bauelement PD zur Umwandlung eines optischen Signals in ein elektrisches Signal angeordnet. Das lichtempfindliche Bauelement PD ist über eine Induktivität L mit einem Übertrager UE verbunden. Die Induktivität L dient zur Anhebung des Frequenzganges des umgewandelten Signales zu höheren Frequenzen hin. Im Übertrager UE erfolgt der erste Teil der Impedanzanpassung zwischen der PIN-Photodiode PD und dem niederohmigen Verstärker BK durch eine dem Fachmann bekannte Weise, wie dies z.B. in der Schrift EP 0 372 742 A2 beschrieben ist. Das Übertragungsverhältnis läßt sich aus der Eingangsimpedanz des niederohmigen Verstärkers BK und dem komplexen Innenwiderstand der PIN-Photodiode PD für ein jeweils zu empfangendes Frequenzband herleiten. Eine Impedanzanpassung bei einem Übertragungsband mit einer unteren Grenzfrequenz $f_{G1}$ = 40 MHz und einer oberen Grenzfrequenz $f_{G2}$ = 550 MHz, einer für dieses Band angenommenen dynamischen Impedanz $Z_D$ = 1 KOhm der PIN-Photodiode und einer Eingangsimpedanz $Z_E$ = 75 Ohm des niederohmigen Verstärkers läßt sich z.B. durch ein Übertragungsverhältnis von 1 zu 3,6 erreichen. Der abgebildete Übertrager UE ist als Spartransformator ausgebildet. An seinem Abgriff liegt das Ausgangssignal des PIN-Moduls PM an. Der Arbeitspunkt der PIN-Photodiode wird über einen Kondensator $C_1$ in einer dem Fachmann bekannten Art und Weise eingestellt.

Als niederohmiger Verstärker BK wird ein als solcher bekannter symmetrischer Gegentaktverstärker in Form eines Moduls, mit dem breitbandige analoge Signale in Kabelfernsehanlagen verstärkt werden können, angeordnet. Solche Verstärker werden z.B. von der Firma Valvo unter der Bezeichnung BGY 584 A, BGY 585 A als Breitbandverstärker-Module in Gegentaktschaltung für Kabelfernanlagen angeboten. Laut Datenblatt 6.88 beträgt die Eingangsimpedanz $Z_E$ = 75 Ohm.

Solche Gegentaktverstärker weisen in der Regel zwei symmetrische Verstärkerzweige auf, in denen jeweils ein gleiches, aber um 180° phasenverschobenes, Signal verstärkt wird. Nach der Verstärkung werden die beiden phasenverschobenen Signale wieder phasengleich zusammengeführt. Durch die 180° Verschiebung in den Verstärkerzweigen und der anschließenden phasengleichen Zusammenführung werden durch die Verstärkung hervorgerufene nichtlineare Verzerrungen, wie Klirren zweiter und höherer Ordnung, verringert. Eine maximale Verringerung des Klirrens wird erreicht, wenn die Signalamplituden in den beiden Verstärkerzweigen gleich groß sind.

Liegt nun eine Fehlanpassung am Eingang des Gegentaktverstärkers vor, führt dies zu unterschiedlichen Signalamplituden in den zwei Verstärkerzweigen und bewirkt hierdurch ein stärkeres Klirren.

Gerade diese Anpassung des komplexen Anteils der Ausgangsimpedanz des PIN-Moduls PM an den Eingang des Verstärkers BK erfolgt durch den $\lambda$/4-Kreis. Der Wellenwiderstand $Z_W$ des $\lambda$/4-Kreises und die Eingangsimpedanz $Z_E$ des niederohmigen Verstärkers sollten dabei möglichst gleich groß sein. Eine Abweichung von z.B. 5 Ohm führt dabei noch zu keiner spürbaren Verschlechterung.

Wenn das PIN-Modul PM und der niederohmige Verstärker BK jeweils als Module aufgebaut sind, ist der $\lambda$/4-Kreis vorteilhafterweise als $\lambda$/4-Leitung in Form einer Mikrowellen-Koaxialleitung mit lösbaren Anschlüssen ausgebildet.

In einer anderen Ausführung kann der $\lambda$/4-Kreis als symmetrische, umkehrbare Vierpolschaltung realisiert werden. Dies bietet sich inbesondere dann an, wenn die Elemente des PIN-Moduls PM und des niederohmigen Verstärkers BK in einer gemeinsamen integrierten Schaltung realisiert sind.

In einer weiteren Ausführung ist der Verstärker BK als isoliertes Modul ausgebildet. Neben der PIN-Photodiode und dem Übertrager UE ist dabei auch der $\lambda$/4-Kreis in Form einer Vierpolschaltung im PIN-Modul PM angeordnet. Da bei dieser Ausführung ein Mikrowellenleiter als Verbindung zwischen dem PIN-Modul PM und dem Verstärkermodul BK notwendig ist, empfiehlt es sich, die Leitungslänge dieses Mikrowellenleiters in die Dimensionierung des $\lambda$/4-Kreises miteinzubeziehen, so daß der $\lambda$/4-Kreis insgesamt aus der Kombination eines Vierpols mit einem Leitungsstück besteht.

Die Vierpolschaltung kann auch vor dem Übertrager UE angeordnet werden und dabei noch die Aufgabe der Spule L übernehmen.

Als integrierte Ausführung eines $\lambda$/4-Kreises kann alternativ zur Vierpolschaltung auch eine in Streifenleitertechnik ausgebildete $\lambda$/4-Leitung angeordnet sein.

In Figur 5 ist die Reduzierung des Klirrens aufgrund des $\lambda$/4-Kreises in einem Breitbandverstärker über der Frequenz aufgetragen. Die Bandbreite ist durch die beiden Grenzfrequenzen, einer unteren Grenzfrequenz $f_{G1}$ = 40 MHz und einer oberen Grenzfrequenz $f_{G2}$ = 550 MHz, eingezeichnet. Das Maximum der Klirreduzierung ist auf 1 nomiert und hat seinen höchsten Wert bei der Frequenz $f_0$, die der Wellenlänge $\lambda_0$ entspricht, auf die der $\lambda$/4-Kreis abgestimmt ist.

Im Ausführungsbeispiel ist die $\lambda$/4-Leitung derart abgestimmt, daß Klirren bei einer Frequenz $f_0$ = 375 MHz maximal unterdrückt wird. Die mechanische Länge $L_m$ der $\lambda$/4-Leitung ergibt sich dabei aus der Gleichung

$$L_m = L_0 \cdot V \qquad (1)$$

mit $L_0$ als elektrische Länge, wobei sich der Wert der Dielektrizitätskonstante der $\lambda$/4-Leitung im Verkürzungsfaktor V, der beim Ausführungsbeispiel V = 0,7 beträgt, niederschlägt. Durch die Bezeichnung

$$L_0 = \frac{c}{f \cdot 4} \qquad (2)$$

in Verbindung mit Gleichung (1) ergibt sich für die Frequenz $f_0 = 375$ MHz, einem Verkürzungsfaktor $V = 0{,}7$ und $C = 3 \cdot 10^8 \frac{m}{s}$, eine mechanische Länge $L_m = 140$ mm. Die elektrische Länge beträgt $L_0 = 200$ mm.

Da das Klirren bei solchen Anordnungen mit zunehmender Frequenz zunimmt und eine maximale Reduzierung des Klirrens, wie aus Figur 2 ersichtlich ist, nur für die abgestimmte Frequenz vorliegt, und die Unterdrückung des Klirrens für Frequenzen mit zunehmender Entfernung zur abgestimmten Frequenz $f_0$ geringer wird, ist der $\lambda/4$-Kreis nicht auf die Mittenfrequenz des Bandes, sondern auf eine Frequenz, die in der höherfrequenten Bandhälfte liegt, abgestimmt. Dies ermöglicht einen Kompromiß zwischen einer maximalen selektiven Reduzierung des Klirrens bei der oberen Grenzfrequenz $f_{G2}$ und einer maximalen integralen Reduzierung des Klirrens bei einer Abstimmung auf einer Mittenfrequenz. Der $\lambda/4$-Kreis wird je nach Anforderung und Ausgestaltung des Empfängers E auf einen vorteilhaften Wert abgestimmt.

Als Signalquelle können neben, als lichtempfindliche Bauelemente ausgebildete PIN-Photodioden auch andere Photodioden, wie z.B. Avalanche-Photodioden, oder z.B. auch Empfangsanschlüsse von Mikrowellenantennen, verwendet werden. Besonders vorteilhaft ist die Anordnung der Erfindung in rein passiven optischen Empfangsmodulen, d.h. in Empfangsmodulen, die keine aktive verstärkende Halbleiterbauelemente enthalten.

**Patentansprüche**

1.  Schaltungsanordnung mit einer eine hochohmige komplexe Ausgangsimpedanz aufweisenden Signalquelle (31, PD) und einem niederohmigen Verstärker (36, BK), **dadurch gekennzeichnet,** daß die Signalquelle (31, PD) an den niederohmigen Verstärker (36, BK) über einen abgestimmten $\frac{\lambda}{4}$-Kreis (35, K) angepaßt ist.

2.  Schaltungsanordnung nach Anspruch 1, dadurch gekennzeichnet, daß die Signalquelle (31) ein in einem optischen Empfänger befindliches, lichtempfindliches Bauelement ist.

3.  Optischer Empfänger nach Anspruch 1, dadurch gekennzeichnet, daß das lichtempfindliche Bauelement (31) am Anfang des $\frac{\lambda}{4}$-Kreises (35) angeschlossen ist.

4.  Optischer Empfänger nach Anspruch 1, dadurch gekennzeichnet, daß der $\frac{\lambda}{4}$-Kreis (35) an seinem Ende kurzgeschlossen ist.

5.  Optischer Empfänger nach Anspruch 1, dadurch gekennzeichnet, daß der Verstärker (36) an der Stelle des $\frac{\lambda}{4}$-Kreises (35) angeschlossen ist, an der der Wellenwiderstand des $\frac{\lambda}{4}$-Kreises 50Ω beträgt.

6.  Optischer Empfänger nach Anspruch 1, dadurch gekennzeichnet, daß der Verstärker (36) eine Eingangsimpedanz von 50Ω hat.

7.  Optischer Empfänger nach Anspruch 1 mit einem Empfindlichkeitsfrequenzbereich, dadurch gekennzeichnet, daß der Empfindlichkeitsfrequenzbereich über einen Abstimmkondensator (38), der am Anfang des $\frac{\lambda}{4}$-Kreises (35) angeschlossen ist, variiert werden kann.

8.  Optischer Empfänger nach Anspruch 1, dadurch gekennzeichnet, daß der Verstärker über einen $n \cdot \frac{\lambda}{4}$-Kreis (n ungerade) angepaßt ist.

9.  Schaltungsanordnung nach Anspruch 1, dadurch gekennzeichnet, daß sie einen Übertrager (UE) aufweist, über den die Signalquelle (PD) an den niederohmigen Verstärker (BK) angepaßt ist, daß der Übertrager (UE) durch den $\lambda/4$-Kreis (K) mit dem niederohmigen Verstärker (BK) verbunden ist, und $\lambda$ eine Wellenlänge im Bandbereich des zu verarbeitenden Signals darstellt.

10. Schaltungsanordnung, nach Anspruch 9, dadurch gekennzeichnet, daß die Wellenlänge $\lambda$ in derjenigen Hälfte des Bandes mit den kürzeren Wellenlängen liegt.

11. Schaltungsanordnung nach Anspruch 9, dadurch gekennzeichnet, daß der $\lambda/4$-Kreis eine $\lambda/4$-Mikrowellenleitung darstellt.

12. Schaltungsanordnung nach Anspruch 11, dadurch gekennzeichnet, daß sich die Signalquelle (PD) und der Übertrager (UE) in einem Modul (PN) befinden, das durch die $\lambda/4$-Mikrowellenleitung mit dem ebenfalls in einem Modul befindlichen niederohmigen Verstärker (BK) lösbar verbunden ist.

13. Schaltungsanordnung nach Anspruch 9, dadurch gekennzeichnet, daß die Eingangsimpedanz des niederohmigen Verstärkers (BK) mit dem Wellenwiderstand des $\lambda/4$-Kreises übereinstimmt.

**14.** Schaltungsanordnung nach Anspruch 9, dadurch gekennzeichnet, daß der Wellenwiderstand des λ/4-Kreises (K) $Z_W$ = 75 Ohm beträgt.

**15.** Schaltungsanordnung nach Anspruch 9, dadurch gekennzeichnet, daß die obere Grenzfrequenz ($f_{G2}$) des zu empfangenden Bandes größer als 500 MHz ist.

**16.** Schaltungsanordnung nach Anspruch 9, dadurch gekennzeichnet, daß die Signalquelle (PD) eine Signalquelle für Analogsignale ist.

**17.** Schaltungsanordnung nach Anspruche 9, dadurch gekennzeichnet, daß sie in einem optischen Breitbandempfänger (E) angeordnet ist und die Signalquelle (PD) als lichtempfindliches Bauelement (PD) ausgebildet ist.

FIG.1A

FIG.1B

FIG.1C

FIG.2

FIG.3

Fig.4

Fig. 5